# EUROPEAN PATENT APPLICATION

(11) **EP 4 333 156 A1**
(43) Date of publication of application: **06.03.2024**
(21) Application number: 23190223.0
(22) Date of filing: 08.08.2023
(51) Int. Cl.: H01M 10/42, H01M 50/519, H01M 50/502, H01M 10/48

(54) **BATTERY MODULE**

(30) Priority: 05.09.2022 JP 2022140756
(71) Applicant: Prime Planet Energy & Solutions, Inc., Chuo-ku Tokyo 103-0022 (JP)
(72) Inventor: INAMURA, Takashi, Tokyo, 103-0022 (JP); KAGEYAMA, Takatoshi, Tokyo, 103-0022 (JP)
(74) Representative: Kuhnen & Wacker Patent- und Rechtsanwaltsbüro PartG mbB

(57) **Abstract**

A flexible printed board (500) includes a first portion (510), a branch portion (500A), and a second portion (520) that branches from the first portion (510) at the branch portion (500A). The first portion (510) of the flexible printed board (500) includes a main body portion (511) and a tip portion (512), and the first portion (510) is connected to the other component (800). A connector portion (1100) is connected to the control board (1000) in an extending direction of the main body portion (511) of the first portion (510). The second portion (520) of the flexible printed board (500) and the control board (1000) are electrically connected to each other via the connector portion (1100). A rising suppression portion (410, 530A) that prevents the flexible printed board (500) from rising from the plate member (400) is provided between the branch portion (520A) and the tip portion of the first portion (510).

## Description

### CROSS REFERENCE TO RELATED APPLICATIONS

This nonprovisional application is based on Japanese Patent Application No. 2022-140756 filed on September 5, 2022 with the Japan Patent Office, the entire contents of which are hereby incorporated by reference.

### BACKGROUND OF THE INVENTION

### Field of the Invention

The present technology relates to a battery module.

### Description of the Background Art

A flexible printed board may be used as a wiring of a battery module including a plurality of battery cells.

Technologies described in WO 2015/107583, Japanese Patent Laying-Open No. 2021-68696, and Japanese Patent Laying-Open No. 2021-72289 are exemplified as background technologies.

### SUMMARY OF THE INVENTION

Since the flexible printed board is likely to be deformed, deflection may occur during assembling to cause unintended rising thereof. It has been required to improve assemblability of the flexible printed board.

It is an object of the present technology to provide a battery module allowing for high assemblability of a flexible printed board.

The present technology provides the following battery module.
[1] A battery module comprising: a plurality of battery cells arranged in a first direction; a plate member provided on the plurality of battery cells; another component provided on the plate member; a flexible printed board provided on the plate member; a control board provided on the plate member and electrically connected to the flexible printed board; and a connector portion provided between the flexible printed board and the control board, wherein the flexible printed board includes a first portion, a branch portion, and a second portion branching from the first portion at the branch portion, the first portion of the flexible printed board includes a main body portion and a tip portion, and the first portion is connected to the other component, the connector portion is connected to the control board in an extending direction of the main body portion of the first portion, the second portion of the flexible printed board and the control board are electrically connected to each other via the connector portion, and a rising suppression portion that prevents the flexible printed board from rising from the plate member is provided between the branch portion and the tip portion of the first portion.
[2] The battery module according to [1], wherein the other component includes a bus bar that is provided on the plate member and that electrically connects the plurality of battery cells.
[3] The battery module according to [1] or [2], wherein the tip portion of the first portion is connected to the other component.
[4] The battery module according to any one of [1] to [3], wherein the rising suppression portion has a function of positioning the flexible printed board on the plate member.
[5] The battery module according to any one of [1] to [4], wherein the rising suppression portion is provided with a protrusion provided in the plate member and a hole provided in the flexible printed board.
[6] The battery module according to any one of [1] to [5], wherein the second portion of the flexible printed board has a substantially L-shape that includes a first side portion extending in a second direction intersecting the first direction and a second side portion extending from the first side portion in the first direction.
[7] The battery module according to any one of [1] to [6], wherein the control board includes a control circuit that controls charging and discharging of each of the plurality of battery cells.

The foregoing and other objects, features, aspects and advantages of the present invention will become more apparent from the following detailed description of the present invention when taken in conjunction with the accompanying drawings.

### BRIEF DESCRIPTION OF THE DRAWINGS

Fig. 1 is a diagram showing a basic configuration of a battery module.
Fig. 2 is a perspective view showing a battery cell.
Fig. 3 is a perspective view showing a state in which a wiring module is provided on the battery module.
Fig. 4 is a diagram showing an arrangement of bus bars in a battery assembly.
Fig. 5 is a first top view of a flexible printed board in the battery module.
Fig. 6 is a cross sectional view showing an exemplary structure around a protrusion of a plate member.
Fig. 7 is a second top view of the flexible printed board in the battery module.
Fig. 8 is a third top view of the flexible printed board in the battery module.

### DESCRIPTION OF THE PREFERRED EMBODIMENTS

Hereinafter, embodiments of the present technology will be described. It should be noted that the same or corresponding portions are denoted by the same reference characters, and may not be described repeatedly.

It should be noted that in the embodiments described below, when reference is made to number, amount, and the like, the scope of the present technology is not necessarily limited to the number, amount, and the like unless otherwise stated particularly. Further, in the embodiments described below, each component is not necessarily essential to the present technology unless otherwise stated particularly. Further, the present technology is not limited to one that necessarily exhibits all the functions and effects stated in the present embodiment.

It should be noted that in the present specification, the terms "comprise", "include", and "have" are open-end terms. That is, when a certain configuration is included, a configuration other than the foregoing configuration may or may not be included.

Also, in the present specification, when geometric terms and terms representing positional/directional relations are used, for example, when terms such as "parallel", "orthogonal", "obliquely at 45°", "coaxial", and "along" are used, these terms permit manufacturing errors or slight fluctuations. In the present specification, when terms representing relative positional relations such as "upper side" and "lower side" are used, each of these terms is used to indicate a relative positional relation in one state, and the relative positional relation may be reversed or turned at any angle in accordance with an installation direction of each mechanism (for example, the entire mechanism is reversed upside down).

In the present specification, the term "battery" is not limited to a lithium ion battery, and may include other batteries such as a nickel-metal hydride battery and a sodium ion battery. In the present specification, the term "electrode" may collectively represent a positive electrode and a negative electrode. Further, the term "electrode plate" may collectively represent a positive electrode plate and a negative electrode plate.

In the present specification, the "battery cell" can be mounted on vehicles such as a hybrid electric vehicle (HEV), a plug-in hybrid electric vehicle (PHEV), and a battery electric vehicle (BEV). It should be noted that the use of the "battery cell" is not limited to the use in a vehicle.

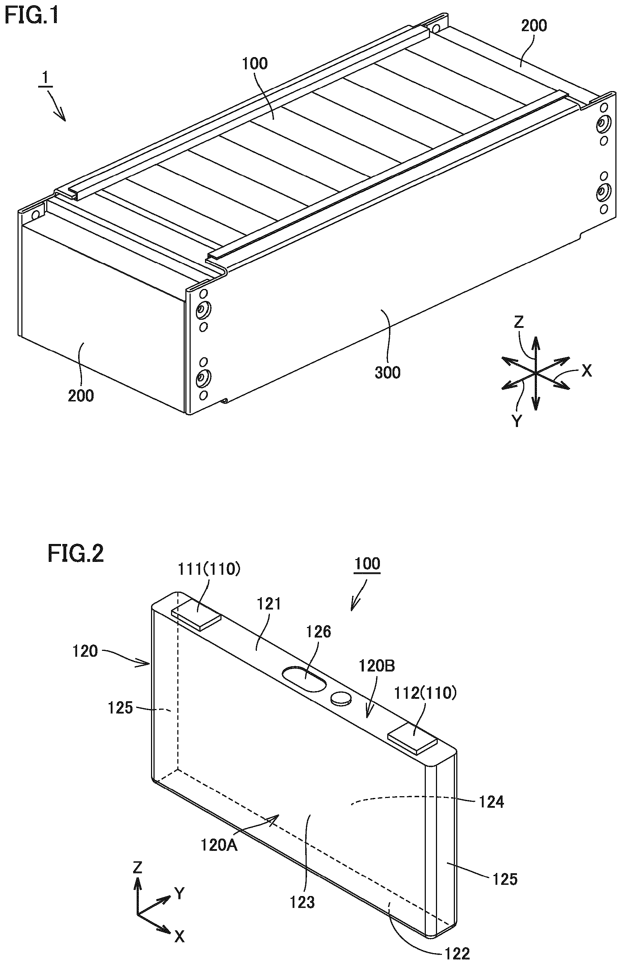

Fig. 1 is a diagram showing a basic configuration of a battery assembly 1. As shown in Fig. 1, battery assembly 1 includes battery cells 100, end plates 200, and a restraint member 300.

The plurality of battery cells 100 are provided side by side in a Y axis direction (first direction). Thus, a stack of battery cells 100 is formed. Each of battery cells 100 includes electrode terminals 110. A separator (not shown) is interposed between the plurality of battery cells 100. The plurality of battery cells 100, which are sandwiched between two end plates 200, are pressed by end plates 200, and are therefore restrained between two end plates 200.

End plates 200 are disposed on both ends of battery assembly 1 in the Y axis direction. Each of end plates 200 is fixed to a base such as a case that accommodates battery assembly 1. Restraint member 300 connects two end plates 200 to each other.

Restraint member 300 is fixed to end plates 200 with a compression force in the Y axis direction being exerted to the stack of the plurality of battery cells 100 and end plates 200, and then the compression force is released, with the result that tensile force acts on restraint member 300 that connects two end plates 200 to each other. As a reaction thereto, restraint member 300 presses two end plates 200 in directions of bringing them closer to each other.

Fig. 2 is a perspective view showing a battery cell 100. As shown in Fig. 2, battery cell 100 has a prismatic shape. Battery cell 100 has electrode terminals 110, and a housing 120 (exterior container). That is, battery cell 100 is a prismatic secondary battery cell.

Electrode terminals 110 are formed on housing 120. Electrode terminals 110 have a positive electrode terminal 111 and a negative electrode terminal 112 arranged side by side along an X axis direction (second direction) orthogonal to the Y axis direction (first direction). Positive electrode terminal 111 and negative electrode terminal 112 are provided to be separated from each other in the X axis direction.

Housing 120 has a rectangular parallelepiped shape and forms an external appearance of battery cell 100. Housing 120 includes: a case main body 120A that accommodates an electrode assembly (not shown) and an electrolyte solution (not shown); and a sealing plate 120B that seals an opening of case main body 120A. Sealing plate 120B is joined to case main body 120A by welding.

Housing 120 has an upper surface 121, a lower surface 122, a first side surface 123, a second side surface 124, and two third side surfaces 125. Housing 120 is provided with a gas-discharge valve 126.

Upper surface 121 is a flat surface orthogonal to a Z axis direction (third direction) orthogonal to the Y axis direction and the X axis direction. Electrode terminals 110 are disposed on upper surface 121. Lower surface 122 faces upper surface 121 along the Z axis direction.

Each of first side surface 123 and second side surface 124 is constituted of a flat surface orthogonal to the Y axis direction. Each of first side surface 123 and second side surface 124 has the largest area among the areas of the plurality of side surfaces of housing 120. Each of first side surface 123 and second side surface 124 has a rectangular shape when viewed in the Y axis direction. Each of first side surface 123 and second side surface 124 has a rectangular shape in which the X axis direction corresponds to the long-side direction and the Z axis direction corresponds to the short-side direction when viewed in the Y axis direction.

A plurality of battery cells 100 are stacked such that first side surfaces 123 of battery cells 100, 100 adjacent to each other in the Y direction face each other and second side surfaces 124 of battery cells 100, 100 adjacent to each other in the Y axis direction face each other. Thus, positive electrode terminals 111 and negative electrode terminals 112 are alternately arranged in the Y axis direction in which the plurality of battery cells 100 are stacked.

Gas-discharge valve 126 is provided in upper surface 121. When the temperature of battery cell 100 is increased (thermal runaway) and internal pressure of housing 120 becomes more than or equal to a predetermined value due to gas generated inside housing 120, gas-discharge valve 126 discharges the gas to outside of housing 120.

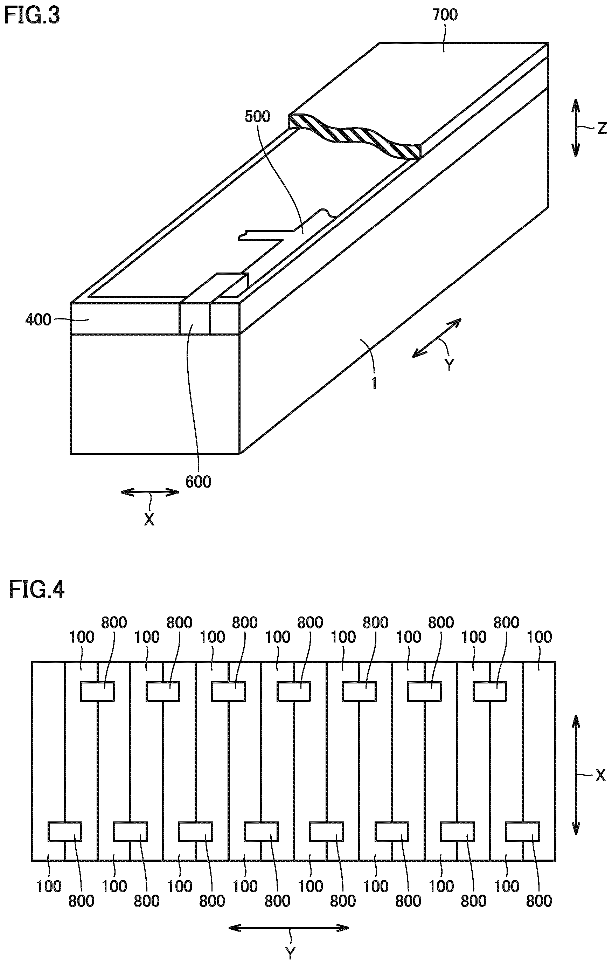

Fig. 3 is a perspective view showing a state in which a wiring module is provided on battery assembly 1. As shown in Fig. 3, a plate member 400 is placed on battery assembly 1, and a flexible printed board 500 is provided on plate member 400. Flexible printed board 500 can be electrically connected to an external device via a connector 600. A cover member 700 is provided on plate member 400 so as to cover flexible printed board 500.

Fig. 4 is a diagram showing an arrangement of bus bars 800 in battery assembly 1. In the example of Fig. 4, positive electrode terminal 111 and negative electrode terminal 112 of adjacent battery cells 100 are electrically connected by bus bar 800, and the plurality of battery cells 100 are electrically connected in series.

That is, battery assembly 1 includes: the plurality of battery cells 100 each having electrode terminals 110 and arranged along a predetermined direction; and bus bars 800 that connect electrode terminals 110 of the plurality of battery cells 100 together.

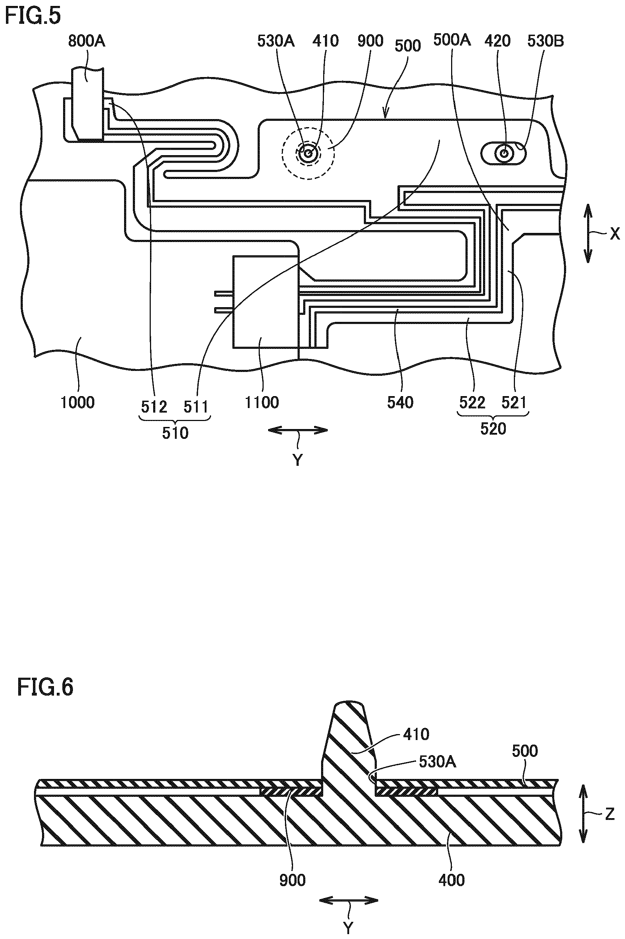

Fig. 5 is a top view of flexible printed board 500 in the battery module. As shown in Fig. 5, flexible printed board 500 is provided on plate member 400. Flexible printed board 500 includes a first portion 510 and a second portion 520.

First portion 510 includes a main body portion 511 and a tip portion 512. In the example shown in Fig. 5, main body portion 511 extends in the Y axis direction. Tip portion 512 is connected to bus bar 800 as "other component" via a bus bar connection portion 800A. Thus, voltage of each bus bar 800 can be detected. However, in the present technology, the "other component" is not limited to bus bar 800, and may be an electronic component such as a temperature sensor or a resistance element. Tip portion 512 is formed at the tip of a portion that is narrower than main body portion 511 and that extends to turn in the shape of U multiple times (twice in the example of Fig. 5). Tip portion 512 has a displacement absorbing function in the Y axis direction. However, in the present technology, the displacement absorbing function of tip portion 512 is not essential.

Second portion 520 branches from first portion 510 at branch portion 500A. Second portion 520 is electrically connected to a control board 1000 via a connector portion 1100. Connector portion 1100 is connected to control board 1000 in the Y axis direction (the extending direction of main body portion 511 of first portion 510). Control board 1000 provided on plate member 400 is electrically connected to flexible printed board 500 by connector portion 1100. Control board 1000 includes a control circuit that controls charging and discharging of each of the plurality of battery cells 100.

Second portion 520 of flexible printed board 500 has a substantially L-shape that includes a first side portion 521 extending in the X axis direction (second direction) intersecting the Y axis direction (first direction) and a second side portion 522 extending from first side portion 521 in the Y axis direction.

Plate member 400 includes protrusions 410, 420. Flexible printed board 500 is provided with hole portions 530A, 530B. Protrusions 410, 420 are inserted into hole portions 530A, 530B, respectively. Flexible printed board 500 is positioned by protrusion 410 and hole portion 530A.

Protrusion 410 and hole portion 530A are provided to be located between tip portion 512 of first portion 510 and branch portion 500A located between first portion 510 and second portion 520.

Flexible printed board 500 has an electrical circuit 540. Thus, battery cell 100 and control board 1000 can be electrically connected to each other.

Thus, protrusion 410 provided in plate member 400 and hole portion 530A provided in flexible printed board 500 constitute a "rising suppression portion" that prevents flexible printed board 500 from rising from plate member 400.

Fig. 6 is a cross sectional view showing an exemplary structure around protrusion 410 of plate member 400. In the example shown in each of Figs. 5 and 6, an adhesive portion 900 that adheres plate member 400 and flexible printed board 500 is provided around protrusion 410. Adhesive portion 900 can improve the function of suppressing the rising of flexible printed board 500 from plate member 400 and the function of positioning flexible printed board 500 on plate member 400. However, in the present technology, adhesive portion 900 is not necessarily an essential configuration.

Since flexible printed board 500 is likely to be deformed, deflection may occur during assembling. For example, when connecting connector portion 1100 to control board 1000, deflection occurs at second portion 520 of flexible printed board 500. This may cause unintended rising of flexible printed board 500. When the unintended rising of flexible printed board 500 is caused, assemblability of flexible printed board 500 may be decreased.

In the battery module according to the present embodiment, since the rising suppression portion of flexible printed board 500 is provided in first portion 510 connected to the other component such as bus bar 800, the rising of first portion 510 of flexible printed board 500 due to the deflection of second portion 520 of flexible printed board 500 can be suppressed when flexible printed board 500 is connected to connector portion 1100. As a result, the assemblability of flexible printed board 500 is improved.

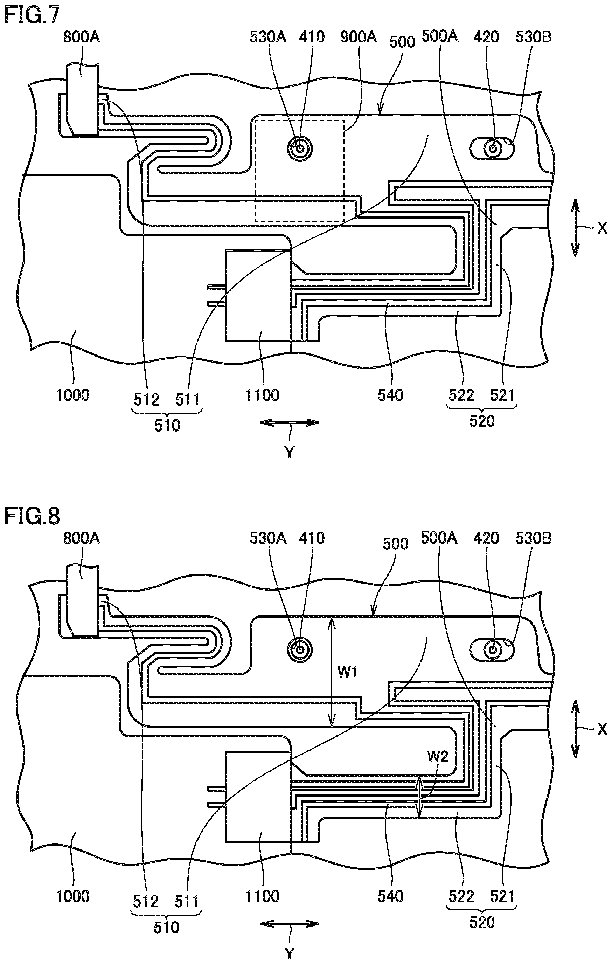

Each of Figs. 7 and 8 is a top view of a flexible printed board 500 according to a modification.

In the example of Fig. 7, a plate member 900A is fixed (adhered) to the rear surface of flexible printed board 500 around protrusion 410. Plate member 900A is constituted of a resin substrate composed of PBT, PP, or the like, or is constituted of a glass epoxy substrate. Thus, flexible printed board 500 can be less likely to be deformed around protrusion 410, thereby preventing flexible printed board 500 from rising from plate member 400 around protrusion 410.

In the example of Fig. 8, adhesive portion 900 (Fig. 5) and plate member 900A (Fig. 7) are not provided; however, since the width (W1) of first portion 510 of flexible printed board 500 around protrusion 410 is larger than the width (W2) of second side portion 522 of second portion 520 connected to connector portion 1100, flexible printed board 500 is relatively less likely to be deformed around protrusion 410, with the result that flexible printed board 500 is prevented from rising from plate member 400 around protrusion 410. Also in this case, it should be interpreted that the "rising suppression portion" is formed.

Further, the thickness of flexible printed board 500 may be increased in a predetermined region of first portion 510 (for example, by providing two flexible printed boards 500 on each other), with the result that flexible printed board 500 can be relatively less likely to be deformed in the predetermined region.

In the present embodiment, the structure in which bus bar 800 serving as the "other component" is connected to tip portion 512 of first portion 510 has been illustratively described; however, the present technology is not limited thereto. The "other component" may be connected to a position of first portion 510 away from tip portion 512 (for example, an end portion of first portion 510 opposite to tip portion 512).

Although the embodiments of the present invention have been described and illustrated in detail, it is clearly understood that the same is by way of illustration and example only and is not to be taken by way of limitation, the scope of the present invention being interpreted by the terms of the appended claims. The scope of the present invention is defined by the terms of the claims, and is intended to include any modifications within the scope and meaning equivalent to the terms of the claims.

## Claims

1. A battery module comprising:
a plurality of battery cells (100) arranged in a first direction;
a plate member (400) provided on the plurality of battery cells (100);
another component (800) provided on the plate member (400);
a flexible printed board (500) provided on the plate member (400);
a control board (1000) provided on the plate member (400) and electrically connected to the flexible printed board (500); and
a connector portion (1100) provided between the flexible printed board (500) and the control board (1000), wherein
the flexible printed board (500) includes a first portion (510), a branch portion (500A), and a second portion (520) branching from the first portion (510) at the branch portion (500A),
the first portion (510) of the flexible printed board (500) includes a main body portion (511) and a tip portion (512), and the first portion (510) is connected to the other component (800),
the connector portion (1100) is connected to the control board (1000) in an extending direction of the main body portion (511) of the first portion (510),
the second portion (520) of the flexible printed board (500) and the control board (1000) are electrically connected to each other via the connector portion (1100), and
a rising suppression portion (410, 530A) that prevents the flexible printed board (500) from rising from the plate member (400) is provided between the branch portion (500A) and the tip portion (512) of the first portion (510).

2. The battery module according to claim 1, wherein the other component (800) includes a bus bar (800) that is provided on the plate member (400) and that electrically connects the plurality of battery cells (100).

3. The battery module according to claim 1 or 2, wherein the tip portion (512) of the first portion (510) is connected to the other component (800).

4. The battery module according to any one of claims 1 to 3, wherein the rising suppression portion (410, 530A) has a function of positioning the flexible printed board (500) on the plate member (400).

5. The battery module according to any one of claims 1 to 4, wherein the rising suppression portion (410, 530A) is provided with a protrusion (410) provided in the plate member (400) and a hole (530A) provided in the flexible printed board (500).

6. The battery module according to any one of claims 1 to 5, wherein the second portion (520) of the flexible printed board (500) has a substantially L-shape that includes a first side portion (521) extending in a second direction intersecting the first direction and a second side portion (522) extending from the first side portion (521) in the first direction.

7. The battery module according to any one of claims 1 to 6, wherein the control board (1000) includes a control circuit that controls charging and discharging of each of the plurality of battery cells (100).
